Europäisches Patentamt

European Patent Office

Office européen des brevets

(19)

(11) Publication number: **0 067 840**
**B1**

# (12) EUROPEAN PATENT SPECIFICATION

(45) Date of publication of patent specification: **12.08.87**

(21) Application number: **82900177.5**

(22) Date of filing: **30.11.81**

(86) International application number:
**PCT/US81/01576**

(87) International publication number:
**WO 82/02284 08.07.82 Gazette 82/17**

(51) Int. Cl.⁴: **H 01 L 21/306, B 44 C 1/22,
C 03 C 14/00**

(54) METHOD OF FABRICATING A SOLID STATE ELECTROOPTICAL DEVICE HAVING A TRANSPARENT METAL OXIDE ELECTRODE.

(30) Priority: **22.12.80 US 219167**

(43) Date of publication of application:
**29.12.82 Bulletin 82/52**

(45) Publication of the grant of the patent:
**12.08.87 Bulletin 87/33**

(84) Designated Contracting States:
**DE FR GB NL**

(56) References cited:
**GB-A-1 289 075
US-A-3 740 280
US-A-3 928 658
US-A-3 941 630
US-A-4 012 767
US-A-4 172 004
US-A-4 184 909

CHEMICAL ABSTRACTS, vol. 88, no. 6,
February 1978, page 224, no. 41302k,
Columbus, Ohio, US; & JP - A - 77 68 860
(HITACHI, LTD.) 08-06-1977**

(73) Proprietor: **EASTMAN KODAK COMPANY
343 State Street
Rochester New York 14650 (US)**

(72) Inventor: **SMITH, Frank Thomas John
62 Copper Woods
Pittsford, NY 14534 (US)**

(74) Representative: **Baron, Paul Alexander Clifford
Kodak Limited Patent Department
Headstone Drive
Harrow Middlesex HA1 4TY (GB)**

Courier Press, Leamington Spa, England.

## Description

The present invention relates to methods of fabricating solid-state electrooptical devices of the type that include transparent metal oxide electrodes.

Solid-state electrooptical devices, such as charge coupled device (CCD) image sensing arrays, in which light passes through, or around a gate electrode on the device, are well known. In the earliest of such devices, the gate electrodes were aluminum and therefore opaque. Small gaps were left between the electrodes through which light could pass. The presence of these small gaps caused serious problems in manufacturing the devices and imposed limitations on the performance of the devices. Shorts frequently occurred across the narrow gaps between the electrodes, rendering the devices useless. The presence of the bare gaps caused fringing fields in the devices that reduced their charge transfer efficiency. Finally, the relatively small light responsive surface area of the devices severely restricted their light gathering efficiency.

An improvement in the manufacturability and performance of the front illuminated CCD image sensing arrays was achieved by the use of semitransparent polysilicon as the electrode material. The article entitled "Charge Coupled Area Image Sensor Using Three Levels of Polysilicon" by C. H. Sequin et al, IEEE Transactions on Electronic Devices, Vol. ED 21, No. 11, Nov. 1974, describes a three-phase CCD image sensor using three levels of semitransparent polysilicon electrodes. With the semitransparent electrode material, gaps between the electrodes were no longer required to allow light to enter the device from the front side. As a result, the electrodes were allowed to slightly overlap (with an interposed layer of insulating material such as $SiO_2$) thereby reducing the probability of shorts between the electrodes, and greatly improving the transfer efficiency of the device by reducing the fringing fields caused by gaps between the electrodes.

The polysilicon electrodes still had the disadvantage that, being only semitransparent, they absorbed some of the light reaching the surface of the device and thereby limited the light gathering efficiency of the device. A proposed solution to this problem was to use a more transparent conductive material such as indium oxide or tin oxide for the electrodes. Unfortunately, there are several problems associated with the use of a transparent conductive metal oxide for the electrodes in an electrooptic device. For one thing, conventional photoresists may not adhere at all well to the metal oxide layers in the presence of the concentrated or hot acids commonly required to etch these layers, making patterning photolithography difficult. A second problem is that it is difficult to make good electrical contact between the transparent metal oxide electrode structure and the final metal layer through which electrical contact is made with the "outside" world because such layer, which typically comprises either gold or aluminum, will either not adhere well to the metal oxide layer or will form an undesirable insulating oxide interface (e.g. aluminum oxide) due to the reduction of the transparent metal oxide by the aluminum. A third problem is the need to pattern (i.e. contour) the final metallization layer without affecting the transparent metal oxide electrodes, in light of the fact that the transparent metal oxide electrodes are attacked by conventional metal etchants in the presence of a strongly reducing metal such as aluminum.

U.S. Patent No. 3,941,630 issued to R. D. Larrabee on March 2, 1976, discloses one method of patterning transparent metal oxide electrodes in a CCD image sensing device. According to the method disclosed by Larrabee, a transparent metal oxide layer is deposited on the surface of the device, and the metal oxide layer is covered with a thin layer of aluminum. The aluminum is patterned using photolithographic techniques and an etchant that does not substantially attack the transparent metal oxide. The remaining aluminum is anodized, leaving a transparent insulating pattern of aluminum oxide on the transparent metal oxide. The aluminum oxide pattern is then employed as a resist to pattern the transparent metal oxide, leaving a pattern of transparent metal oxide electrodes covered by an insulating layer of transparent aluminum oxide. While providing a method for patterning transparent metal oxide electrodes, this method does not solve the second and third problems noted above.

According to the present invention, the problems identified above are solved by using a translation metal (e.g. chromium) as the patterning metal in the Larrabee process outlined above. Such a metal is advantageous from the standpoint that it adheres well to the metal oxide layer, does not react with the metal oxide layer to form an undesirable non-conductive oxide at the interface, and can be chemically etched by an etchant which does not attack the metal oxide layer. To form a patterned transparent metal oxide electrode atop a solid state substrate in accordance with the invention, a layer of transparent metal oxide is first deposited on the substrate. Thereafter, a transition metal layer is deposited atop the metal oxide layer. Through photolithography or other conventional equivalent techniques, portions of the transition metal layer are etched away to expose the underlying portions of the metal oxide layer, such as by using an etchant that selectively attacks only the transition metal. Thereafter, the exposed metal oxide layer is removed, using the patterned transition metal as a mask and an etchant that selectively attacks the metal oxide without substantially attacking the transition metal. This results in a patterned metal oxide electrode having an overlying coating of the transition metal. Finally, the transition metal coating is etched from those areas of the metal oxide electrode which are intended to transmit light to the underlying solid state substrate, leaving behind the transition metal in only the common conductor portion (e.g. the bonding pad areas), so that good electrical contact can be made between the electrode and the biasing and addressing circuitry of the equipment in which the electrooptical device is used. Preferably, a final metallization layer is added, such as a layer of gold or aluminum, atop the remaining portions of the transition metal so as to facilitate such electrical connection.

The invention will be described with reference to the drawings, wherein:

FIGS. 1a and 1b are top plan views of optical masks which are used in carrying out a preferred embodiment of the invention;

FIGS. 2a—8a are cross-sectional views of the common conductor portion of a three-phase CCD image sensing device, showing its construction at various stages of the method of the inventions; and

FIGS. 2b—8b are cross-sectional views of the image-sensing portion of a three-phase CCD image sensing device showing its construction at various stages of the method of the invention.

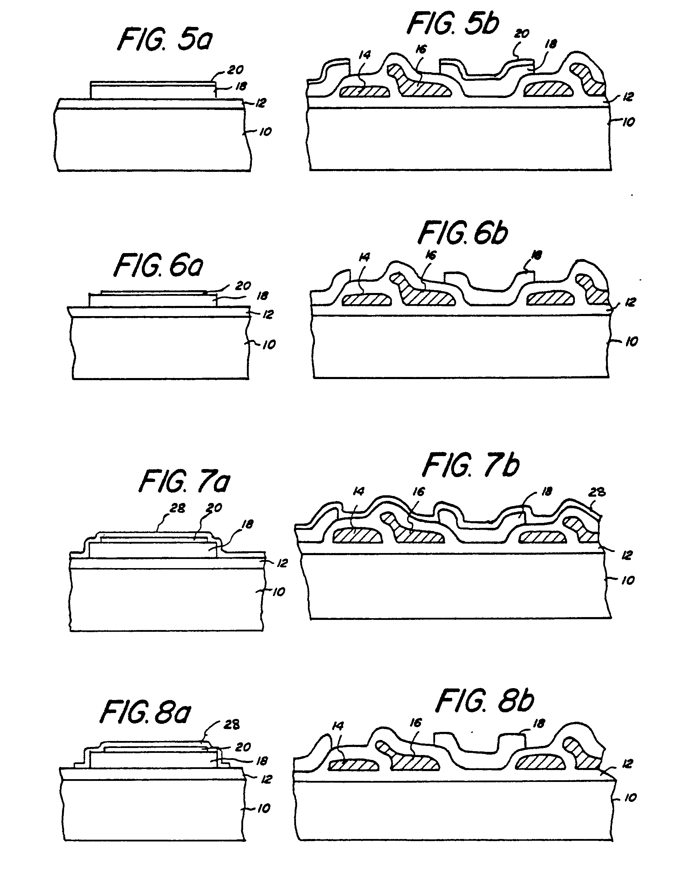

The preferred embodiment of the invention will be described with reference to the manufacture of a three-phase CCD image sensor of the type described in the above-referenced article by Sequin et al. Referring temporarily to FIG. 8b, such a sensor comprises when completed, a suitably doped semiconductive substrate 10 (e.g. p-type silicon) which supports a silicon dioxide layer 12 in which two transparent metal oxide electrodes 14 and 16 (i.e. the first and second phase electrodes) are embedded. Disposed atop of the silicon dioxide layer 12 is a third transparent metal oxide electrode 18. Since the method of the invention can be used to apply any or all of the electrodes 14, 16, 18, and since the method is basically the same for applying any of these electrodes, it is unnecessary to describe the process for applying all three electrodes. Thus, only the method for applying electrode 18 is described below.

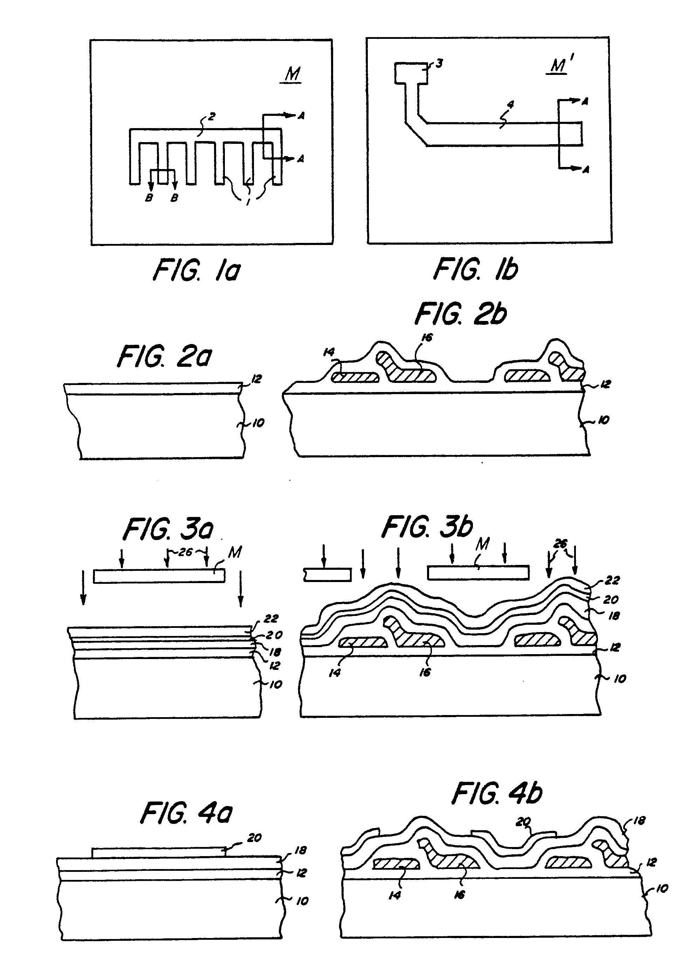

Referring now to FIGS. 2a and 2b, these drawings show, in cross section, an electrode-bearing silicon dioxide layer 12 on which the method of the invention is to be carried out. FIG. 1a is a highly simplified schematic diagram of a mask which represents the desired pattern of the top electrode structure of the three-phase CCD image sensor. That portion of the electrode eventually produced by the laterally-extending, opaque segments 1 of the mask represent the transparent electrodes in the image sensing area of the device. That portion of the electrode eventually produced by the horizontally-extending, opaque portion 2 of the mask is a common conductor that electrically interconnects the transparent top electrodes.

Turning now to FIGS. 3a and 3b, the first step in the method of the invention is to deposit on the electrode-bearing silicon dioxide layer 12 a layer of transparent metal oxide 18, such as $SnO_2$, $In_2O_3$, CdO, $Sb_2O_3$, or mixtures of these. The metal oxide layer 18 is then covered with a layer of "pattern" metal 20, i.e. metal which, by photolithographic techniques, can be selectively etched to form a desired pattern. The pattern metal adheres to the transparent metal oxide forming a good electrical contact therewith, and is capable of being etched independently of the transparent metal oxide, thereby functioning as a resist. Metals suitable for use as the pattern metal are found in a group of transition elements, and include those metals having a relatively high oxidation potential, such as titanium, chromium, tungsten and molybdenum, which upon reducing the transparent metal oxide, produce conductive oxides of their own, and also those metals having a relatively low oxidation potential, such as platinum and gold, which are substantially nonreactive with the transparent metal oxides. Mercury, although a transition metal has too low a melting point to be useful for practicing the invention.

The layer of pattern metal 20 is deposited on the transparent metal oxide layer 18 by any of the well known deposition techniques such as sputtering, evaporation, spraying, electroplating, or electroless deposition. The layer 20 is patterned to the required third phase electrode pattern using photolithography. The layer of pattern metal is covered with a layer of photoresist 22 and the photoresist is exposed through mask M (FIG. 1a) by actinic radiation 26. As indicated above, mask M is opaque to actinic radiation in the electrode structure areas 1 and 2 and transparent elsewhere. The cross-sectional views of FIGS. 2a—8a are taken along a hypothetical section line A—A in FIG. 1a to show the cross-sectional structure in the common conductor portion of the electrode structure during the manufacturing process. Similarly, the cross-sectional views of FIGS. 2b—8b are taken along the section line B—B to show the cross-sectional structure in the light-sensitive (i.e. transparent) portion of the electrode.

Upon imagewise exposing the photoresist layer 22 to the desired electrode pattern, the photoresist is then removed from areas of exposure using conventional techniques. The resulting structure is then subjected to an etchant which serves to remove the pattern metal not protected by the remaining photoresist. Such an etchant, of course, must not attack the underlying transparent metal oxide layer 18. Suitable etchants are found in the class of redox solutions stable in a neutral or weakly acid or alkaline solution, such as $I_2$—KI; $K_3Fe(CN)_6$—$K_4Fe(CN)_6$; $C_6H_4O_2$—$C_4H_6O_2$ (quinone-hydroquinone); $FeCl_3$—$FeCl_2$; and $Ce(NO_3)_2$—$Ce(NO_3)_3$. Thereafter the unexposed photoresist is removed from the pattern metal keaving behind the structures shown in FIGS. 4a and 4b. The remaining pattern metal is used as an inert, highly adherent, resist while the transparent metal oxide layer 18 is etched to the final electrode pattern using an etchant that attacks the transparent metal oxide at a much faster rate than the pattern metal. The resulting structure is shown in FIGS. 5a and 5b.

The pattern metal is again patterned using photolithography and the mask M' shown in FIG. 1b, and a selective etchant is used to remove the pattern metal from the optically active areas of the device (i.e. the areas shown in FIGS. 2b—8b), but not from the common conductor areas (shown in FIGS. 2a—8a) where electrical contacts are to be made. The resulting transparent metal oxide electrode structure 18 in which only the conductor portion is covered with pattern metal 20 is shown in FIGS. 6a and b. To complete the circuit, and form bonding pads for connecting the sensor to a utilization device, a final layer of metal 28 is deposited over the surface of the structure, as shown in FIGS. 7a and b. The structure is then baked at about 300°C to promote adhesion of the final metal to the pattern metal. The final metal is patterned using photolithography and an etchant that attacks the final metal but not the transparent metal oxide. The mask shown in FIG. 1b is again used to pattern the final metal layer. Such a mask provides an electrode structure having a peripheral bonding pad (defined by area 3) which is electrically connected to an elongated conductor (defined by area 4) which is disposed over, and makes electrical contact with the elongated conductor (defined by area 2) of the FIG. 1a mask. The final structure is shown in FIGS. 8a and b.

### Examples
### Example 1

The transparent metal oxide is cadmium-tin oxide prepared by simultaneously sputtering CdO and $SnO_2$ onto the substrate in the approximate proportions of 30% $SnO_2$ and 70% CdO by weight.

The pattern metal is chromium, deposited over the transparent metal oxide approximately 1000 A thick by sputtering or evaporation. The chromium etchant is a mixture of nitric acid (4%), water (80%), and ceric ammonium nitrate (16%). The transparent metal oxide etchant is hydrochloric of hydroiodic acid. The final metal is gold; and the final metal etchant is a concentrated solution of potassium polyiodide.

### Example 2

The same as example 1, except that the final metal is aluminum, and the final metal etchant is a halide-containing plasma such as carbon tetrachloride, applied using standard plasma etching techniques. Such a plasma does not attack the transparent metal oxide.

### Example 3

The pattern metal is gold; and the pattern metal etchant is potassium polyiodide. The transparent metal oxide etchant is hydrochloric or hydroiodic acid. The final metal is gold or aluminum as in Examples 1 and 2 respectively.

The invention has been described in detail with reference to a preferred embodiment thereof, however, it will be understood that variations and modifications can be effected within the scope of the invention as claimed. For example, although the invention has been described with respect to patterning transparent metal oxide electrodes on a light sensitive device, i.e. an image sensor, the method may also be used to pattern transparent metal oxide electrodes on light emitting devices such as LED's.

**Claims**

1. A method of fabricating a solid state electrooptical device in which a patterned metal oxide electrode is formed atop a semiconductive substrate by (1) depositing a uniform layer of conductive transparent metal oxide on such substrate; (2) depositing a layer of metal atop said metal oxide layer; (3) etching the metal layer away to expose the oxide layer according to a desired pattern; and (4) etching away the exposed oxide layer to leave behind a patterned oxide layer having an overlying metal layer, said method being characterized in that said metal layer comprises a transition metal, preferably chromium, and in that said process further includes the step of etching away the transition metal in the light-sensitive regions of the device, leaving behind the transition metal in those areas in which electrical contact is to be made with the device.

2. The method as defined by claim 1 further characterized by the steps of depositing a final layer of metal, preferably gold or aluminum, atop the structure, baking the structure at a temperature sufficient to promote adhesion between the final metal layer and the transition metal layer, and etching away portions of the final metal layer to define electrically conductive paths and bonding pads.

3. The method as defined by claim 1 characterized in that the etchant for the transition metal layer is a mixture of nitric acid, water and ceric ammonium nitrate.

4. The method as defined by claim 2 characterized in that the etchant for the final metal layer is a solution of potassium polyiodide or a halide containing plasma.

**Patentansprüche**

1. Verfahren zur Herstellung einer elektro-optischen Halbleitervorrichtung, bei dem eine mit einem Muster versehene Metalloxidelektrode auf einem Halbleitersubstrat ausgebildet wird, indem (1.) auf das Substrat eine gleichförmige Schicht aus leitfähigem transparentem Metalloxid aufgebracht wird, (2.) eine Metallschicht auf der Metalloxidschicht aufgetragen wird, (3.) die Metallschicht weggeätzt und die Oxidschicht gemäß einem gewünschten Muster freigelegt wird und (4.) die freigelegte Oxidschicht weggeätzt und eine ein Muster bildende Oxidschicht zurückbehalten wird, die mit einer Metallschicht überzogen ist, dadurch gekennzeichnet, daß die Metallschicht ein Übergangsmetall, vorzugsweise Chrom, aufweist, und daß das Übergangsmetall in den lichtempfindlichen Bereichen der Vorrichtung weggeätzt wird und nur in den Bereichen

7 0 067 840 8

zurückbleibt, in denen mit der Vorrichtung ein elektrischer Kontakt hergestellt werden soll.

2. Verfahren nach Anspruch 1, dadurch gekennzeichnet, daß eine letzte Metallschicht, vorzugsweise eine Gold- oder Aluminiumschicht, auf die Anordnung aufgebracht wird, daß die Anordnung bei einer Temperatur gebacken wird, die ausreicht, um eine Haftung zwischen der letzen Metallschicht und der aus dem Übergangsmetall bestehenden Schicht zu erzielen, und daß Teile der letzten Metallschicht so weggeätzt werden, daß elektrische leiterbahnen und Anschlußstücke entstehen.

3. Verfahren nach Anspruch 1, dadurch gekennzeichnet, daß das Ätzmittel für die aus einem Übergangsmetall bestehende Schicht eine Mischung aus Salpetersäure, Wasser und Ceriumammoniumnitrat ist.

4. Verfahren nach Anspruch 2, dadurch gekennzeichnet, daß das Ätzmittel für die letzte Metallschicht eine Lösung aus Kaliumpolyjodid oder einem plasmahaltigen Halogenid ist.

**Revendications**

1. Procédé de fabrication d'un dispositif électro-optique d'état solide dans lequel on forme sur le dessus d'un substrat semiconducteur, une électrode d'oxyde métallique présentant une configuration déterminée, par: 1) dépôt, sur ledit substrat, d'une couche uniforme d'un oxyde métallique conducteur transparent; 2) dépôt, sur ladite couche d'oxyde métallique, d'une couche de métal; 3) décapage de la couche de métal de manière à dégager ladite couche d'oxyde métallique suivant une configuration déterminée; 4) décapage de ladite couche d'oxyde métallique dégagée de manière à obtenir, après décapage, une couche d'oxyde présentant la configuration déterminée et surmontée d'une couche de métal, procédé caractérisé en ce que ladite couche de métal est constituée d'un métal de transition, de préférence du chrome, et en ce qu'il comprend l'étape supplémentaire de décapage du métal de transition dans les régions du dispositif qui sont sensibles à la lumière de manière à ne laisser la couche de métal de transition que dans les zones dans lesquelles on doit établir les contacts électriques avec le dispositif.

2. Procédé conforme à la revendication 1, caractérisé en ce qu'il comprend les étapes ultérieures: 1) de dépôt d'une dernière couche de métal, de préférence d'or ou aluminium, sur le dessus de la structure, 2) de cuisson de la structure à une température suffisante pour que la dernière couche de métal adhère à la couche de métal de transition, et 3) de décapage des zones de la dernière couche de métal afin de définir les zones conductrices et les pattes de soudage.

3. Procédé conforme à la revendication 1, caractérisé en ce que l'on utilise un mélange d'eau, d'acide nitrique et de nitrate d'ammonium cérique pour décaper la couche de métal de transition.

4. Procédé conforme à la revendication 2, caractérisé en ce que l'on utilise un plasma contenant un halogénure ou une solution de polyiodure de potassium pour décaper la dernière couche de métal.

0 067 840

FIG. 1a

FIG. 1b

FIG. 2a

FIG. 2b

FIG. 3a

FIG. 3b

FIG. 4a

FIG. 4b

1

FIG. 5a

FIG. 5b

FIG. 6a

FIG. 6b

FIG. 7a

FIG. 7b

FIG. 8a

FIG. 8b

2